# FASCICULE DE BREVET EUROPEEN

(11) **EP 2 416 168 B1**
(45) Date de publication et mention de la délivrance du brevet: **15.05.2013**
(21) Numéro de dépôt: 10305827.7
(22) Date de dépôt: 26.07.2010
(51) Int. Cl.: G01R 31/40, H02M 7/521, G01R 31/327, G01R 31/42, H02M 7/797, G01R 31/27

(54) **Banc de test pour blocs de puissance électroniques.**
Prüfstand für leistungs-elektronische Blöcke
Test bench for power electronic blocks.

(43) Date de publication de la demande: 08.02.2012
(73) Titulaire: Semikron, 78500 Sartrouville (FR)
(72) Inventeur: Lebreton, Philippe, 78420 Carrieres-sur-Seine (FR)
(74) Mandataire: Littolff, Denis

(56) Documents cités:
- EP-A1- 1 420 262
- EP-A1- 2 144 360
- EP-A2- 1 211 797
- EP-A2- 1 608 055
- WO-A2-01/47094
- WO-A2-2008/027867
- DE-A1- 10 127 776
- DE-A1-102009 020 911
- JP-A- 2005 312 265
- US-A1- 2007 119 820

## Description

La présente invention a trait à un banc de test pour blocs de puissance électroniques basés sur des bras de ponts comportant chacun une paire de transistors de puissance de type IGBT protégés par une diode, et associables pour former de tels blocs remplissant des fonctions distinctes selon le nombre de bras de ponts associés.

En fait, ces derniers constituent en l'occurrence l'élément essentiel de base, en quelque sorte une brique modulaire permettant de réaliser des dispositifs distincts, en pratique des convertisseurs dont l'application varie selon le nombre de briques modulaires individuelles associées. La réunion de deux d'entre elles permet par exemple de constituer un pont en H, alors que le raccordement de trois bras de ponts permet notamment la réalisation d'un onduleur.

La présente invention a été conçue pour tester électriquement et fonctionnellement des blocs de puissance différents précisément en ce qu'ils comportent un nombre variable de bras de ponts. Leur comportement électrique, et par conséquent les contraintes appliquées et caractéristiques requises au/pour le banc de test changent selon le bloc à tester, les courants supportés variant en particulier selon la configuration soumise au test.

Jusqu'ici, dans les systèmes de test existants, seul le produit fini était en général testé. Les charges étaient alors choisies en fonction du produit à tester, dans le domaine d'application qui devrait devenir le sien, le mode de contrôle de commande dudit produit respectant le contexte technique d'utilisation du convertisseur testé. L'inconvénient principal d'un test global ainsi mis en oeuvre réside notamment dans le fait que la défaillance d'un des sous-ensembles du produit fini est susceptible d'affecter la totalité du produit, voire de l'endommager plus ou moins gravement.

Secondairement, le test du dispositif complet, constitué comme on l'a vu d'un certain nombre de sous-ensembles associés, peut ralentir considérablement l'identification du défaut ou de la panne, la recherche organisée sur le produit complexe s'avérant évidemment plus longue ou plus compliquée.

L'invention remédie à ces inconvénients en proposant un banc permettant de tester indifféremment des fractions plus ou moins complètes des produits, d'ailleurs susceptibles de constituer en elles-mêmes des produits remplissant d'autres fonctions, ainsi que leur assemblage sous diverses formes. L'approche est donc modulaire, la validation des produits s'effectuant, au gré des utilisateurs, par modules individualisés ou par groupement de modules.

A cet effet, le banc de test de blocs de puissance électroniques de l'invention se caractérise en ce qu'il est constitué d'un convertisseur à quatre bras de pont comportant chacun une paire de transistors de puissance de type IGBT protégés par une diode, chaque bras étant raccordé à une inductance connectée en série en sortie du bras, une interface de connexion dudit banc aux blocs comportant des moyens de modifier les couplages des inductances.

La configuration électrique du banc de test est donc basée sur l'utilisation de quatre bras de pont de type IGBT, c'est-à-dire de quatre phases qui fonctionnent avec un calibre en courant qui dépend comme on le verra dans la suite des produits à tester. En fait, le banc de l'invention est lui même basé sur une association de blocs de puissance du même type que ceux qui sont à tester, dont le rôle est d'ajuster le point de fonctionnement lors du test.

L'interface de connexion, qui réalise l'adaptation des modalités de connexion du banc de test aux diverses configurations de blocs de puissance à tester, dépend en pratique du nombre de bras de pont associés. Le raccordement des deux pôles + et ― doit à cet égard être faiblement inductif, afin de n'avoir qu'une influence négligeable sur les tests réalisés.

En particulier, l'interface de connexion comporte des moyens de connexion en étoile des extrémités libres des inductances situées à l'opposé de leur raccordement aux bras de pont du banc de test. Dans ce cas, le banc de test est configuré de manière à pouvoir tester un module « brique » individuellement, c'est-à-dire un unique bras de pont.

Alternativement, l'interface de connexion comporte des moyens de connexion par paire des extrémités libres des inductances. Cette hypothèse vise les cas où le dispositif à tester est un pont en H, constitué à partir de deux bras de pont individuels.

Enfin, selon une autre possibilité encore, cette interface de connexion peut comporter des moyens de connexion pour chacune des extrémités libres des trois inductances. Il s'agit là du cas d'un dispositif triphasé, par exemple un onduleur, un redresseur, etc... L'invention permet bien de tester l'équipement et le fonctionnement de blocs de puissance qui présentent des fonctions électriques différentes, mettant en jeu des courants différents.

De préférence, l'interface de connexion comporte des moyens manuels ou automatisés de modifier l'état des moyens de connexion par commande de moyens de couplage des extrémités libres des inductances.

Plus précisément, cette interface est configurée de telle sorte à pouvoir, par des modifications mécaniques, mettre en relation différentes extrémités libres des inductances dans certaines hypothèses, ou à l'inverse de les rendre ou maintenir non couplées.

Selon une possibilité, les moyens de modifier les couplages des inductances consistent en pratique en des câbles avec des connecteurs, par exemple des connecteurs de puissance rapides permettant de procéder rapidement et facilement aux changements de couplage requis par les types de blocs de puissance à tester.

Les inductances sont elles-mêmes calibrées pour un courant lₒ égal au plus petit calibre d'une phase des blocs à tester.

Globalement, le banc de test de l'invention est soumis à un courant de calibre quatre fois lₒ lorsque le test se fait sur un unique bras de pont, de calibre deux fois lₒ pour un test sur un pont en H, et de calibre lₒ pour tester un onduleur par exemple ou plus généralement un convertisseur triphasé. II doit pouvoir fonctionner avec un certain niveau de courant, lequel peut se présenter en une phase (calibre 4lₒ), en deux phases (calibre 2lₒ), ou encore en trois phases (calibre lₒ).

L'invention concerne également l'association d'un banc de test tel que décrit auparavant et de blocs qui sont basés sur des bras de pont comportant chacun une paire de transistors de puissance de type IGBT et protégés par une diode, associables pour former de tels blocs remplissant des fonctions distinctes selon le nombre de bras de pont associés, caractérisé en ce que les différents blocs de puissance électroniques sont agencés en un unique bloc mécanique présentant une même interface mécanique de connexion au banc de test.

Le bloc mécanique en lui-même diffère peu d'une configuration à l'autre, au moins pour ce qui concerne son encombrement volumique et ses modalités de raccordement. En revanche, l'intérieur comporte un ou plusieurs bras de pont, selon sa fonction. Le test mis en oeuvre sur le banc dépendra par conséquent de la configuration interne du bloc de puissance à tester.

II est à noter que le système de contrôle du banc permet de piloter non seulement les blocs de puissance à tester, mais également les blocs de puissance du banc proprement dit.

L'invention va à présent être décrite plus en détail, en référence aux différents dessins annexés, pour lesquels :
- la figure 1 symbolise de manière générale les différentes possibilités d'utilisation du banc de test de l'invention, et montre la configuration électronique de ce dernier ;
- les figures 2 et 3 montrent de manière plus précise l'adaptation du banc d'essai aux configurations de blocs de puissance montrées non connectées en figure 1.

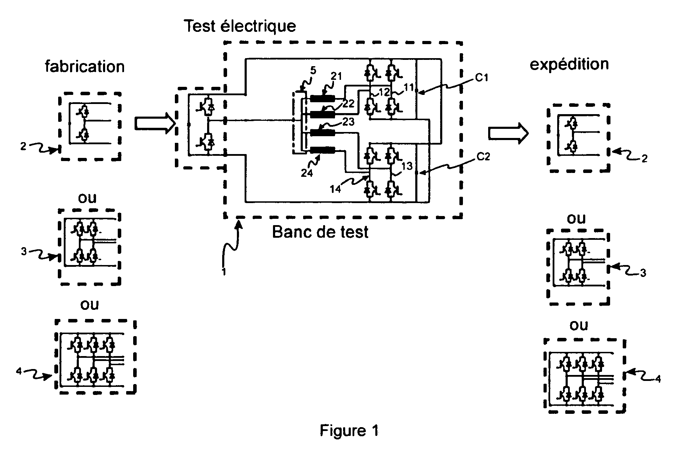

En référence à la figure 1, le banc de test (1) est utilisable pour des modules distincts, basés sur les « briques élémentaires » dont il a été question plus haut, et qui sont référencées (2), (3) ou (4). Ce banc de test (1) comporte quatre bras de pont (11, 12, 13, 14), découplés par paires (11, 12 ; 13, 14) par deux capacités (C1, C2).

En sortie, les bras de pont (11, 12, 13, 14) sont respectivement connectés à des inductances (21, 22, 23, 24). Des moyens de connexion (5) permettent d'adapter la configuration des extrémités libres des inductances (21, 22, 23, 24) à différentes configurations de blocs de puissance en cours de test.

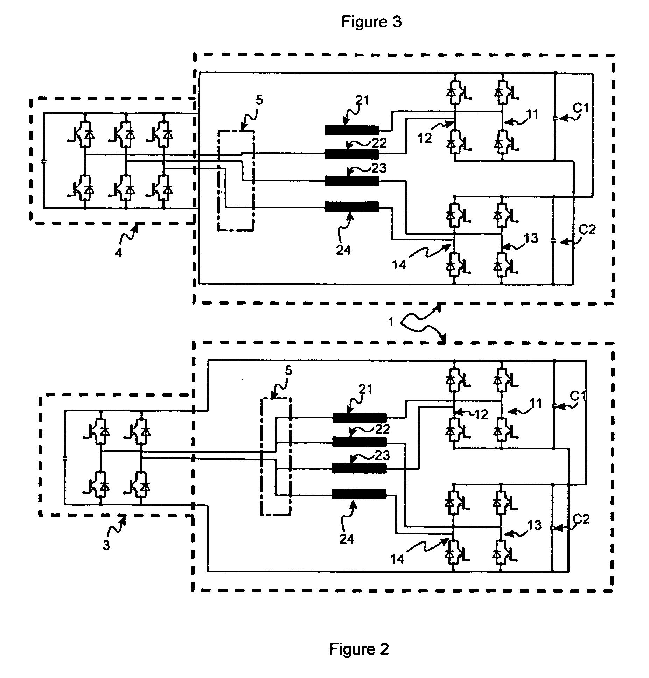

En figure 1, le test est appliqué à un bloc de puissance (2) comportant un unique bras de pont. Alternativement, il peut bien entendu s'agir des deux autres blocs de puissance (3, 4), comportant respectivement deux et trois bras de pont (voir respectivement en figures 2 et 3). Le test a lieu, comme cela est schématiquement représenté dans la figure 1, en sortie de la fabrication des blocs de puissance (2 à 4), et avant leur expédition. Cette dernière n'intervient bien entendu que lorsque les tests se sont avérés satisfaisants. La fonction du banc de test selon l'invention s'inscrit donc dans un process industriel.

Les figures 2 et 3 précisent la configuration exacte de l'association banc de test (1)/bloc de puissance (3,4) dans les deux hypothèses qui ne sont pas montrées en figure 1. Ainsi, en figure 2, il s'agit d'un pont en H qui est soumis au test réalisé par le banc (1), alors qu'en figure 3, le bloc de puissance (4) soumis au test est un onduleur, comportant dès lors trois bras de pont.

Entre les configurations des figures 1, 2 et 3, le seul changement dans le banc de test (1) réside dans le couplage des extrémités libres des inductances (21, 22, 23, 24) en sortie des bras de pont (11, 12, 13, 14) équipant le banc de test (1), pour les adapter aux blocs de puissance (2 à 4) soumis au test.

Ainsi, les moyens de connexion (5) voient eux-mêmes leur configuration modifiée de telle sorte qu'ils puissent connecter deux sorties issues de bras de pont distincts en figure 2, et de trois bras de pont distincts en figure 3.

A cet égard, il est intéressant de noter que dans cette dernière hypothèse l'inductance (21) n'est pas connectée en sortie alors qu'elle l'est dans les configurations des figures 1 et 2. En fait, en figure 1, les moyens de connexion (5) organisent un couplage en étoile de la totalité des sorties des inductances (21, 22, 23, 24), la sortie des moyens de connexion (5) étant alors unique. En figure 2, les inductances (21, 22 ; 23, 24) sont organisées par paires, dans le couplage mis en oeuvre dans les moyens de connexion (5), aboutissant en deux voies de sortie aptes à être connectées aux deux sorties des bras de pont du bloc de puissance (3).

Enfin, les moyens de connexion (5) sont configurés de telle sorte que, en figure 3, les inductances (22, 23, 24) sont maintenues non connectées à d'autres inductances, résultant en trois voies de sortie pouvant être connectées aux sorties des trois bras de pont du bloc de puissance (4). Dans cette hypothèse, l'inductance (21) n'est couplée à aucune inductance par les moyens de connexion (5).

Les moyens de connexion (5) mettent donc en adéquation avec le nombre de sortie des blocs de puissance (2, 3, 4) le nombre de points de raccordement du banc (1).

L'invention n'est pas limitée aux exemples illustrés par les figures 1 à 3 commentées ci-dessus, mais englobe au contraire toutes les variantes de forme qui entrent dans la portée des revendications.

## Revendications

1. Banc de test (1) de blocs de puissance (2, 3, 4) électroniques basés sur des bras de ponts comportant chacun une paire de transistors de puissance de type IGBT protégés par une diode, et associables pour former de tels blocs (2, 3, 4) remplissant des fonctions distinctes selon le nombre de bras de pont associés, **caractérisé en ce qu'**il est constitué d'un convertisseur à quatre bras de pont (11, 12, 13, 14) comportant chacun une paire de transistors de puissance de type IGBT protégés par une diode, chaque bras (11, 12, 13, 14) étant raccordé à une inductance (21, 22, 23, 24) connectée en série en sortie du bras, une interface de connexion dudit banc aux blocs (2, 3, 4) comportant des moyens (5) de modifier les couplages des inductances (21, 22, 23, 24).

2. Banc de test (1) selon la revendication précédente, **caractérisé en ce que** l'interface de connexion comporte des moyens de connexion (5) en étoile des extrémités libres des inductances (21, 22, 23, 24) situées à l'opposé de leur raccordement aux bras de pont (11, 12, 13, 14) du banc de test (1).

3. Banc de test (1) selon l'une des revendications précédentes, **caractérisé en ce que** l'interface de connexion comporte des moyens de connexion (5) par paire des extrémités libres des inductances (21, 22, 23, 24) situées à l'opposé de leur raccordement aux bras de pont (11, 12, 13, 14) du banc de test (1).

4. Banc de test (1) selon l'une des revendications précédentes, **caractérisé en ce que** l'interface de connexion comporte des moyens de connexion (5) pour chacune des extrémités libres de trois inductances (22, 23, 24) situées à l'opposé de leur raccordement aux bras de pont (11, 12, 13, 14) du banc de test (1).

5. Banc de test (1) selon l'une des revendications 2 à 4, **caractérisé en ce que** l'interface de connexion comporte des moyens manuels ou automatisés de modifier l'état des moyens de connexion (5) par commande de moyens de couplage des extrémités libres des inductances (21, 22, 23, 24).

6. Banc de test (1) selon la revendication précédente, **caractérisé en ce que** les moyens de modifier les couplages des inductances (21, 22, 23, 24) consistent en des câbles munis de connecteurs de puissance rapides.

7. Banc de test (1) selon l'une des revendications précédentes, **caractérisé en ce que** les inductances (21, 22, 23, 24) sont calibrées pour un courant Iₒ égal au plus petit calibre d'une phase des blocs (2, 3, 4) à tester.

8. Association d'un banc de test (1) de blocs de puissance électroniques selon les revendications précédentes et desdits blocs (2, 3, 4) basés sur des bras de pont comportant chacun une paire de transistors de puissance de type IGBT et protégés par une diode, associables pour former de tels blocs (2, 3, 4) remplissant des fonctions distinctes selon le nombre de bras de pont associés, **caractérisée en ce que** les différents blocs de puissance (2, 3, 4) électroniques sont agencés en un unique bloc mécanique présentant une même interface mécanique de connexion au banc de test (1).

## Patentansprüche

1. Prüfstand (1) für leistungs-elektronische Blöcke (2, 3, 4), basierend auf Brückenarmen, umfassend jeweils ein Paar Leistungstransistoren vom Typ IGBT, geschützt von einer Diode und assoziierbar, um derartige Blöcke (2, 3, 4) zu bilden, die verschiedene Funktionen erfüllen, je nach der Anzahl der assoziierten Brückenarme, **dadurch gekennzeichnet, dass** er aus einem Umwandler mit vier Brückenarmen (11, 12, 13, 14) besteht, umfassend jeweils ein Paar Leistungstransistoren vom Typ IGBT, geschützt von einer Diode, wobei jeder Arm (11, 12, 13, 14) mit einer Induktanz (21, 22, 23, 24) verbunden ist, die in Reihe am Ausgang des Arms angeschlossen ist, wobei ein Anschluss des Prüfstands (2, 3, 4) Mittel (5) umfasst, um die Kopplungen der Induktanzen (21, 22, 23, 24) zu modifizieren.

2. Prüfstand (1) nach dem vorhergehenden Anspruch, **dadurch gekennzeichnet, dass** die Verbindungsschnittstelle sternförmige Anschlussmittel (5) der freien Enden der Induktanzen (21, 22, 23, 24) umfasst, die sich gegenüber ihrem Anschluss mit den Brückenarmen (11, 12, 13, 14) der Prüfbank (1) befinden.

3. Prüfstand (1) nach einem der vorhergehenden Ansprüche, **dadurch gekennzeichnet, dass** die Anschlussschnittstelle paarweise Verbindungsmittel (5) der freien Enden der Induktanzen (21, 22, 23, 24) umfasst, die sich gegenüber ihrem Anschluss mit den Brückenarmen (11, 12, 13, 14) des Prüfstands (1) befinden.

4. Prüfstand (1) nach einem der vorhergehenden Ansprüche, **dadurch gekennzeichnet, dass** die Anschlussschnittstelle Anschlussmittel (5) für jedes der freien Enden der drei Induktanzen (22, 23, 24) umfasst, die sich gegenüber ihrem Anschluss mit den Brückenarmen (11, 12, 13, 14) des Prüfstands (1) befinden.

5. Prüfstand (1) nach einem der Ansprüche 2 bis 4, **dadurch gekennzeichnet, dass** die Verbindungsschnittstelle manuelle oder automatisierte Mittel zur Veränderung des Zustands der Anschlussmittel (5) durch die Steuerung von Kopplungsmitteln der freien Enden der Induktanzen (21, 22, 23, 24) umfasst.

6. Prüfstand (1) nach dem vorhergehenden Anspruch, **dadurch gekennzeichnet, dass** die Mittel zur Veränderung der Kopplungen der Induktanzen (21, 22, 23, 24) aus Kabeln bestehen, die mit schnellen Leistungsanschlüssen ausgestattet sind.

7. Prüfstand (1) nach einem der vorhergehenden Ansprüche, **dadurch gekennzeichnet, dass** die Induktanzen (21, 22, 23, 24) für einen IQ-Strom kalibriert sind, der gleich dem kleinsten Kaliber einer Phase der zu prüfenden Blöcke (2, 3, 4) ist.

8. Assoziierung eines Prüfstands (1) von elektronischen Leistungsblöcken nach den vorhergehenden Ansprüchen, und wobei die unteren Blöcke (2, 3, 4) auf Brückenarmen jeweils ein Paar Leistungstransistoren vom Typ IGBT umfassen, und geschützt von einer Diode, assoziierbar, um derartige Blöcke (2, 3, 4) zu bilden, die verschiedene Funktionen erfüllen, je nach der Anzahl der assoziierten Brückenarme, **dadurch gekennzeichnet, dass** die verschiedenen elektronischen Leistungsblöcke (2, 3, 4) in einem einzigen mechanischen Block angeordnet ist, der eine gleiche mechanische Schnittstelle zur Verbindung mit der Prüfbank (1) umfasst.

## Claims

1. A test bench (1) for power electronic blocks (2, 3, 4) based on bridge arms each including a pair of power transistors of the IGBT type protected by a diode, and associable to form such blocks (2, 3, 4) performing distinct functions depending on the number of associated bridge arms, **characterized in that** it is made up of a converter with four bridge arms (11, 12, 13, 14) each including a pair of power transistors of the IGBT type protected by a diode, each arm (11, 12, 13, 14) being connected to an induction coil (21, 22, 23, 24) connected serially at the output of the arm, a connection interface for connecting said bench to the blocks (2, 3, 4) including means (5) for modifying the connections of the induction coils (21, 22, 23, 24).

2. The test bench (1) according to the preceding claims, **characterized in that** the connection interface includes star connection means (5) for the free ends of the induction coils (21, 22, 23, 24) situated opposite their connection to the bridge arms (11, 12, 13, 14) of the test bench (1).

3. The test bench (1) according to one of the preceding claims, **characterized in that** the connection interface includes connection means (5) for connection by pairs of the free end of the induction coils (21, 22, 23, 24) situated opposite their connection to the bridge arms (11, 12, 13, 14) of the test bench (1).

4. The test bench (1) according to one of the preceding claims, **characterized in that** the connection interface includes connection means (5) for each of the free ends of three induction coils (22, 23, 24) situated opposite their connection to the bridge arms (11, 12, 13, 14) of the test bench (1).

5. The test bench (1) according to one of claims 2 to 4, **characterized in that** the connection interface includes manual or automated means for modifying the state of the connection means (5) by controlling coupling means of the free ends of the induction coils (21, 22, 23, 24).

6. The test bench (1) according to the preceding claims, **characterized in that** the means for modifying the connections of the induction coils (21, 22, 23, 24) consist of cables provided with quick power connectors.

7. The test bench (1) according to one of the preceding claims, **characterized in that** the induction coils (21, 22, 23, 24) are calibrated for a current Iₒ equal to the smallest caliber of a phase of the blocks (2, 3, 4) to be tested.

8. An association of a test bench (1) for electronic power blocks according to the preceding claims and said blocks (2, 3, 4) based on bridge arms each including a pair of power transistors of the IGBT type and protected by a diode, associable to form such blocks (2, 3, 4) performing distinct functions depending on the number of associated bridge arms, **characterized in that** the different electronic power blocs (2, 3, 4) are arranged in a single mechanical block having a same mechanical connection interface to the test bench (1).
